# EUROPEAN PATENT APPLICATION

(11) **EP 1 927 434 A1**
(43) Date of publication of application: **04.06.2008**
(21) Application number: 07023031.3
(22) Date of filing: 28.11.2007
(51) Int. Cl.: B24B 37/04, B24B 53/02, B24B 53/12

(54) **CMP conditioner**

(30) Priority: 29.11.2006 JP 2006321542
(71) Applicant: MITSUBISHI MATERIALS CORPORATION, Chiyoda-ku, Tokyo 100-8117 (JP)
(72) Inventor: Rikita, Naoki, Omiya-ku Saitama-shi Saitama 330-8508 (JP); Chida, Kasumi, Omiya-ku Saitama-shi Saitama 330-8508 (JP)
(74) Representative: HOFFMANN EITLE

(57) **Abstract**

To provide a CMP conditioner that prevents dissolution of metals in slurry, without the chipping of the abrasive grains and/or decreasing the cutting performance.

[Issues to be solved by the invention]

The CMP apparatus has a polishing pad that faces and contacts conditioning surface 2 of the conditioner body 1. On this conditioning surface 2, abrasive grains 3 are distributed and fixed to form abrasive grain layer 5, thus forming the CMP conditioner. The conditioner body 1 is made of ceramics, the abrasive grains 3 in the abrasive grain layer 5 are held by binding phase 4 made of low temperature co-fired ceramics.

## Description

### [Field of the invention]

The present invention relates to a CMP conditioner for conditioning the polishing pad of a CMP (Chemical Mechanical Polishing) apparatus that polishes semiconductor wafers and the like.

### [Description of related art]

Various kinds of CMP conditioners in which abrasive grains are fixed by metal plating binding phase of Ni and the like, on a base metal plate, such as stainless steel have been reported. When highly corrosive strong acid or strong alkaline slurry is used in a CMP apparatus, the binding phase metal is dissolved, it become undesirable to polish semiconductor wafers in such slurry with dissolved metals. To avoid this problem, for example, patent documents 1 and 2 disclose a CMP conditioner in which ceramics is employed as the binding phase.
[Patent Document 1] Japanese Patent No. 527448
[Patent Document 2] Japanese Patent application Publication No. 2005-288685

### [Disclosure of the invention]

### [Problems to be solved by the invention]

In the CMP conditioner disclosed in Patent Documents 1 and 2, the ceramics binding phase is sintered for adhesion of abrasive grains at the high temperature of 1200°C. At such a high temperature, for example, if the abrasive grains are diamond super-abrasive grains, surfaces of the super-abrasive grains became carbonized and blackened by the heat and chipping tends to occur. On the other hand, to prevent the surfaces from such carbonation by the heat, if the surfaces of the diamond super-abrasive grains are coated as disclosed in Patent Documents 1 and 2, the cutting performance of the polishing pad by such super-abrasive grains became poor, which results in decrease of the pad polishing rate.

### [Summary of the invention]

With such background, this invention aims to provide a CMP conditioner which restricts metal dissolution in the slurry, without causing the chipping of the abrasive grains and/or decreasing the cutting performance.

### [Solution of the problem]

To overcome the above problems and accomplish the above objective, this invention features a CMP conditioner comprised of a conditioner body, facing and in contact with the polishing pad of the CMP apparatus; the CMP conditioner having an abrasive grain layer formed on the conditioning surface of the conditioning body; the abrasive grains distributed and fixed on the abrasive grain layer: The above mentioned conditioner body is made of ceramics, and the binding phase holding and fixing the abrasive grains in the abrasive grain layer is made of low temperature co-fired ceramics (LTCC).

The abrasive grains in the CMP conditioner are held in the binding phase, which is made of low temperature co-fired ceramics; these low temperature co-fired ceramics are known to compose semiconductor substrates that can be sintered at relatively low temperatures of 1000°C or below. Therefore even the diamond super-abrasive grains need no surface coating, as the carbonization and/or chipping by the sintering is prevented. In addition, the abrasive grain layer holding the abrasive grains is formed on the binding phase; this layer and the conditioning surface of the conditioner body are made of the same ceramics: Thus the CMP conditioner with the above structure can highly restrict metal dissolution in strong acid or strong alkaline slurry.

Although it is possible to use pre-sintered ceramics for the ceramics composing the conditioner body, if the body is made of the low temperature co-fired ceramics, and the binding phase uses the same low temperature co-fired ceramics, the conditioner body can be sintered integrally with the binding phase. An example of the low temperature co-fired ceramics that can be used to compose the binding phase and/or the conditioner body is MgO-SiO₂ ceramics. Preferably, spark plasma sintering (SPS) should be used for sintering. Since it is difficult to make holes for screws in the ceramics conditioner body to attach the CMP conditioner to the CMP apparatus, it is preferable that sections of the conditioner body are supported by a chassis made of resin, except for the conditioning surface.

### [Effects of the Invention]

The CMP conditioner of this invention can prevent metal dissolution in slurry without causing the chipping of the abrasive grains and/or decreasing the cutting performance. Thus, it is possible to prevent, with reliability, semiconductor wafers from becoming contaminated by dissolved metals, and/or defects due to scratches, etc., from the abrasive grains in the CMP apparatus; thereby the polishing pad is in reliable condition, allowing efficient polishing of the semiconductor wafers.

### [Brief Description of the Drawings]

Fig. 1 is a sectional view showing the CMP conditioner according to an embodiment of the invention.
Fig. 2 is a sectional view showing an example of conditioner material sintered at low temperature during the fabrication of the CMP conditioner shown in Fig. 1.
Fig. 3 is a sectional view showing another example of conditioner material sintered at low temperature during the fabrication of the CMP conditioner shown in Fig. 1.
Fig. 4 is a sectional view showing still another example of conditioner material sintered at low temperature during the fabrication of the CMP conditioner shown in Fig. 1.
Fig. 5 is a sectional view showing yet another example of conditioner material sintered at low temperature during the fabrication of the CMP conditioner shown in Fig. 1.

### [Description of Reference Numbers and Signs]

- 1:: Conditioner body
- 2:: Conditioning surface
- 3:: Abrasive grains
- 4:: Binding phase
- 5:: Abrasive grain layer
- 6:: Chassis
- 11:: Ceramic base
- 12:: Low temperature co-fired sheet ceramics
- 13:: Paste
- 15:: Ceramic materials
- 14, 16:: Release agent

### [Detailed Description of Referenced Embodiments]

### [The best Mode of the Invention]

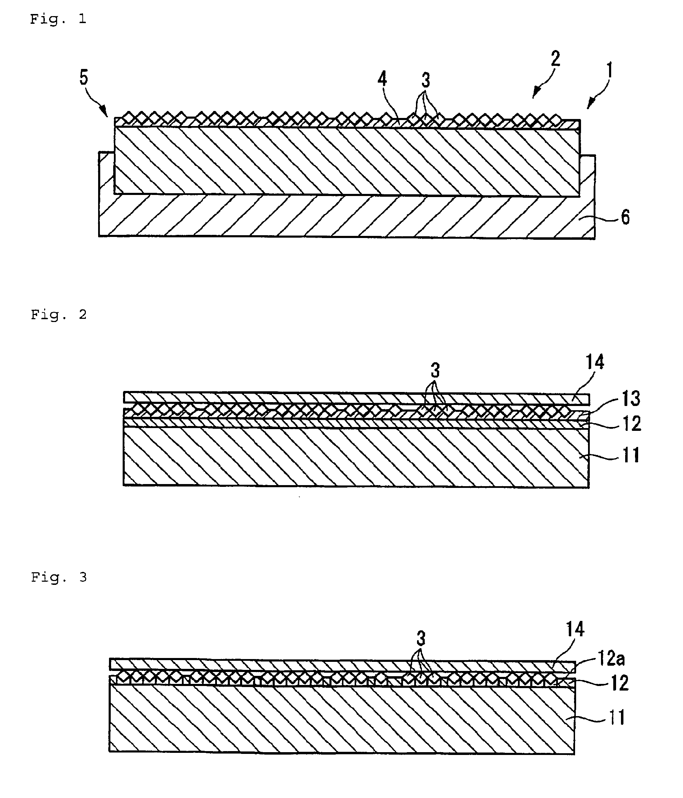

Fig. 1 is a sectional view showing the CMP conditioner according to an embodiment of the invention. The CMP conditioner of this example has a disc shaped conditioner body 1: One of the surfaces is a conditioning surface 2, that faces and contacts the CMP conditioner's polishing pad: This conditioning surface 2, has abrasive grains 3 distributed, then fixed with binding phase 4; thus forming adhesive layer 5. The circumferential surface of conditioner body 1, and the opposite side of the conditioning surface 2, are attached to resin chassis 6; the chassis 6 has a contour that fits the dimensions of the conditioner.

In this embodiment, the abrasive grains 3 are diamond super-abrasive grains that have about the same average diameter, which are arranged approximately in a regular grid on the conditioning surface 2. The abrasive grains 3 protrude from the binding phase 4 surface by pressure adjustment during fabrication.

The binding phase 4 is made of low temperature co-fired ceramics; this embodiment uses MgO-SiO₂ ceramics and the conditioner body 1 is also made of MgO-SiO₂ or SiC ceramics.

To fabricate this CMP conditioner: On one circular side of a disc-shaped base of pre-sintered ceramics, the abrasive grains 3 are distributed and arranged, then they are sintered at temperatures lower than 1000°C. Preferably, this sintering is preformed using spark plasma sintering; in which a raw object is placed in a mold structured by carbon dies and punches; this is placed under pressure and sintered using spark plasma generated by applying direct pulse currents to that raw object.

Fig. 2 shows the abovementioned raw object as an example of conditioner material, during fabrication of the CMP conditioner in this embodiment. In this example, a pre-sintered ceramic base 11 made of MgO-SiO₂ or SiC, one surface of this will become the conditioning surface 2; on this surface, a layer of low temperature co-fired sheet ceramics material 12 made of abovementioned materials, in the form of a sheet or foil with the thickness of 1 mm or less is placed: On that, abrasive grains 3 such as diamond super-abrasive grains, etc., are adhered using paste 13: On top of that alumina powder, SiC powder, or a sheet made of the granulation of these powders; these are placed as release agent 14.

To prepare such conditioner material: for example, an abovementioned low temperature co-fired sheet ceramics material 12 is cut to fit the dimensions of the ceramics base 11; this sheet has abovementioned liquid paste 13 sprayed on it; on the sprayed surface, mesh having the grid size of the average grain size of abrasive grains 3 is placed; then the abrasive grains 3 are distributed on the mesh: The abrasive grains 3 that pass though the mesh are adhered by paste 13; the surplus grains 3 are removed by wiping, then the mesh is removed. Thus the fixed abrasive grains 3 form a uniform grid pattern that matches the mesh: Then the low temperature co-fired sheet ceramics material 12 with the abrasive grains 3 fixed on it, is placed on the surface of the ceramic base 11; a coat of the abovementioned release agent 14 is placed on it, thus forming the conditioner material shown in Fig. 2.

The obtained conditioner material is set in the abovementioned mold, then placed in the spark plasma sintering system that will perform the spark plasma sintering: As the spark plasma sintering is performed under pressure, the abrasive grains 3 sink into the low temperature co-fired ceramics material 12, then the low temperature co-fired ceramics material 12 with the abrasive grains 3 fixed, becomes integrated with ceramic base 11; thus the abovementioned CMP conditioner body 1 will have, on it's conditioning surface 2; a firmly fixed single layer of abrasive grains 3, this becomes the abrasive grain layer 5: The fabrication of the CMP conditioner of the embodiment is completed when the chassis 6, is attached to the CMP conditioner body 1.

In CMP conditioners with such structure, the abrasive grain layer 5 has abrasive grains 3 fixed with binding phase 4; this binding phase 4 is formed when the low temperature co-fired ceramics material 12 is sintered, at the sintering temperature of 1000 °C or lower. For example, in this embodiment, the diameter of the conditioning surface 2 is 30 mm, the abrasive grains 3 are diamond super-abrasive grains with the average grain size of 280 µm, the abovementioned low temperature co-fired sheet ceramics material 12 is made of MgO-SiO₂ ceramics, at the thickness is about 0.4 mm: To sinter this by spark plasma sintering, the abovementioned material is pressured at 20 KN for 1 minute at room temperature, then the temperature is increased to 650 °C in 5 minutes, next, the temperature is increased to 750 °C in 1 minute, the temperature is further increased to 800 °C for 1 minute, maintained at 800 °C for 1 minute, decreased to 300 °C in 10 minutes, then removed from the mold and cooled at room temperature, thus obtaining the abovementioned conditioner body 1.

If the abrasive grains 3 and low temperature co-fired ceramics material 12 is the same as above, and the conditioner surface 2 diameter is 98 mm: To sinter this by spark plasma sintering, the material is pressured at 20 KN for 1 minute at room temperature, then the temperature is increased 150 °C in 4 minutes, next, the temperature is increased to 700 °C in 5 minutes, temperature increased to 800 °C in 2 minutes, temperature increased to 850 °C in 2 minutes, the temperature is maintained at 850 °C for 1 minute, then the temperature is decreased to 300 °C in 100 minutes, then removed from the mold and cooled at room temperature.

Dissolution of one or several metals such as Fe, Co, Ni, Cu, and Zn occurs in CMP conditioners using metal plating phase as the binding phase: In CMP conditioners in this embodiment, fabricated and structured as previously mentioned, the conditioner body 1 is made of ceramics including the abrasive grain layer 5 and the binding phase 4; thus, there is very little such dissolution, 1 ppm or less, or no dissolution at all: If strong alkaline or strong acid slurry is used in the CMP conditioner, the conditioner body 1 will not corrode or the abrasive grains 3 is not dissociated. The conditioner body 1, made of ceramics, is mounted onto chassis 6, made of resin: attachments to join it to the CMP apparatus, such as screw holes can be made on chassis 6; there is no need to machine the conditioner body 1.

In our abovementioned CMP conditioner, the abovementioned binding phase 4 is made of low temperature co-fired ceramics material 12 such as MgO-SiO₂ ceramics; the sintering temperature is 1000 °C or lower; thus, if the abrasive grains 3 are diamond super-abrasive grains, they do not become blackened or carbonized and there is no need to coat the surface of the abrasive grains 3: The chipping that occurs in the abrasive grains 3 and the poor cutting performance by coating, leading to decrease the polishing rate of pad, are prevented. In our CMP conditioner with the abovementioned structure, the wafer contamination due to dissolved metals or the scratches on the wafers from the chipping of abrasive grains can be prevented, while the polishing pad is in reliable condition, thus making possible efficient polishing of semiconductor wafers.

To fabricate such CMP conditioners, the abovementioned fabrication method uses, as conditioner material 12, low temperature co-fired ceramics material mentioned in the embodiment; this is sintered by spark plasma sintering: This spark plasma sintering makes it possible to increase the temperature of the raw object in a relatively short period of time; it is also possible to sinter at lower temperatures, thus reliably preventing damage to abrasive grains 3. Compared to sintering performed in a conventional electric oven, the binding phase 4 sintered by spark plasma sintering has lesser pores and a denser structure; the Al₂O₃ particles as a filler have sufficiently melted, hence almost none of Al₂O₃ remains as spherical shape, thus making it possible to reliability retain abrasive grains 3.

An example of the above mentioned conditioner materials used to fabricate the conditioning body 1 of such CMP conditioners: A low temperature co-fired sheet ceramics material 12 is placed on the surface of the abovementioned pre-sintered ceramic base 11, on that, abrasive grains 3, such as diamond super-abrasive grains are arrayed regularly by a mesh, and adhered by paste 13. Another example of preferable structure is shown in Fig. 3: A pre-sintered ceramic base 11 has a low temperature co-fired sheet ceramics material 12 cut to fit the dimensions of the surface of the ceramic base 11; numerous holes 12a in a grid pattern are opened in the sheet, the hole size being approximately the same or somewhat smaller than the average diameter of the abrasive grains 3: Abrasive grains 3, in this case diamond super-abrasive grains are distributed on the holes 12a, the surplus abrasive grains 3 that did not fit in the holes 12a are removed; then low temperature co-fired ceramics material 12 with the abrasive grains 3 are placed on the surface of base 11, on that, an alumina sheet is placed as released agent 14.

The abovementioned materials are sintered, preferably by spark plasma sintering, to construct a CMP conditioner. Since the structure of this CMP conditioner is the same as the conditioner of the embodiment, the efficiency is the same. Furthermore, the same sintering conditions are applied to the embodiment and the abovementioned materials.

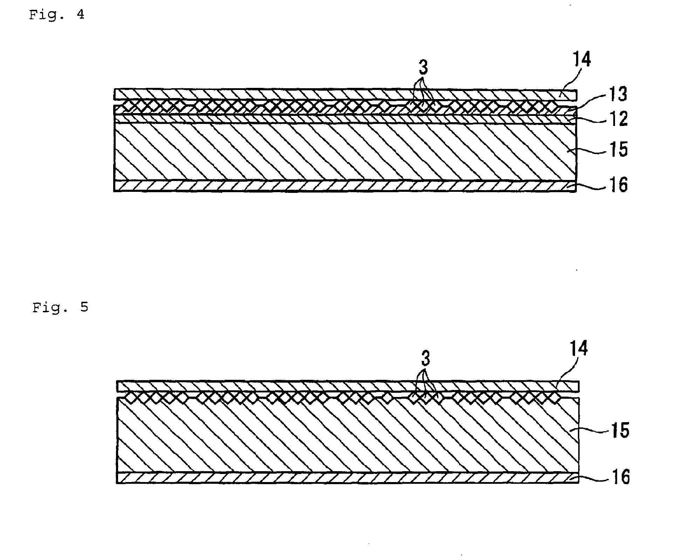

As shown in these examples, conditioner body 1 with an integrated abrasive grain layer 5 is formed by: A pre-sintered ceramic base 11 has low temperature co-fired ceramics material 12 placed on it, then it is sintered at low temperatures. Fig. 4 shows other examples of conditioner material: A mold, preferably from a spark plasma sintering system, has, as release agent, ceramics coat agent placed in it, then the ceramic material 15 in powder form is spread on the release agent 16. Placed on top of the ceramic material 15 is, in one abovementioned example, a low temperature co-fired sheet ceramics material 12 with the abrasive grains 3; these are the same material as placed on the surface of ceramic base 11: In another abovementioned example, the same low temperature co-fired sheet ceramics material 12, has holes 12a opened in it to attach the abrasive grains 3, then, an alumina sheet is placed on top as release agent 14: Then low temperature sintering is performed on both cases.

When low temperature co-fired ceramics material 12 is placed on ceramic material 15 and sintered at low temperatures, it is preferable that both ceramic material 15 and low temperature co-fired ceramics material 12 used here are the same materials: Thus the whole conditioner body 1, including the binding phase 4 and abrasive grain layer 5, can be efficiently sintered together at low temperature: If low temperature co-fired ceramics material 12 and material 15 with the binding phase 4 are sintered together, the CMP conditioner has an abrasive grain layer 5 with a higher ability to retain the abrasive grains 3. This advantage is especially evident when both low temperature co-fired ceramics material 12 and material 15 are the same low temperature co-fired ceramics material, such as MgO-SiO₂ ceramics.

In these before-mentioned other examples, the conditioner body 1 is integrally molded by low temperature co-fired ceramics materials 15 placed in a mold, then sintered. In yet another example, shown in Fig. 5: As the material of the raw object, the mold has release agent 16 put in; on that, material 15 is spread, then the diamond super-abrasive grains 3 are directly arrayed regularly; on that an alumina sheet is placed as release agent 14, and then, sintered at low temperatures. In this case, abrasive grains 3 are fixed in binding phase 4; forming abrasive layer 5, thus the whole of conditioner body 1 is formed by the integrated sintering of low temperature co-fired ceramics: thus the ability to retain the abrasive grains 3 increases.

In conditioner material (s) shown in Fig. 4 and Fig. 5, the powder form material 15 is spread in a mold, then sintered together at low temperatures with binding phase 4. If the abrasive grains 3 and low temperature co-fired ceramics material 12 are the same as the abovementioned example; and if the material 15 in powder form and the low temperature co-fired ceramics material 12 are of the same composition: To sinter a conditioner body 1 having a conditioning surface 2 with a diameter of 30 mm by using the spark sintering plasma: The material is pressured to 20 KN at room temperature for 1 minute, then the temperature is increased to 650°C in 5 minutes, the temperature is increased to 750°C in 1 minute, the temperature is increased to 800°C in 1 minute. These steps are the same as the abovementioned example; the next step differs from the abovementioned case in that the whole conditioner body 1 including material 15 is sintered; thus it is maintained at 800°C for 5 minutes. Afterwards is the same as the abovementioned example, the temperature is decreased to 300°C in 10 minutes, taken out of the mold and cooled at room temperature.

## Claims

1. A CMP conditioner comprising a conditioner body that faces and contacts the polishing pad of a CMP apparatus, and an abrasive grain layer formed on a conditioning surface of the conditioning body, abrasive grains being distributed and adhered on the abrasive grain layer, the CMP conditioner being **characterized in that** the conditioner body is made of ceramics and a binding phase holding the abrasive grains in the abrasive grain layer is made of low temperature co-fired ceramics.

2. The CMP conditioner according to Claim 1, wherein the conditioner body is made of low temperature co-fired ceramics.

3. The CMP conditioner according to Claim 1 or Claim 2, wherein the low temperature co-fired ceramics is MgO-SiO₂ ceramics.

4. The CMP conditioner according to any one of Claims 1 to 3, wherein sections other than the conditioning surface of the conditioner body are supported by a chassis made of resin.
